# EUROPEAN PATENT APPLICATION

(11) **EP 4 036 624 A1**
(43) Date of publication of application: **03.08.2022**
(21) Application number: 20869693.0
(22) Date of filing: 25.09.2020
(51) Int. Cl.: G02B 7/00, F21V 29/502, F21Y 115/00, F21Y 115/30, H01L 33/00, H01L 33/50, H01L 33/64, G02B 5/20, F21S 41/16, F21S 41/176, F21S 43/13, F21S 43/16, F21S 45/10, F21S 45/47, F21W 102/00, F21W 103/00, H01S 5/02, H01S 5/024

(54) **LIGHT-EMITTING DEVICE, WAVELENGTH CONVERSION UNIT, AND HEADLIGHT OR DISPLAY DEVICE**

(30) Priority: 27.09.2019 JP 2019177695
(71) Applicant: Sony Group Corporation, Tokyo 108-0075 (JP)
(72) Inventor: WADA, Satoshi, Kiyosu-shi, Aichi 452-8564 (JP); HAYASHI, Kento, Kiyosu-shi, Aichi 452-8564 (JP); KAWAMURA, Yuhki, Kiyosu-shi, Aichi 452-8564 (JP); MURAYAMA, Masahiro, Tokyo 108-0075 (JP); MOTOBAYASHI, Hisayoshi, Tokyo 108-0075 (JP); TAKIGUCHI, Yoshiro, Tokyo 108-0075 (JP); KAWANISHI, Hidekazu, Tokyo 108-0075 (JP); YANASHIMA, Katsunori, Tokyo 108-0075 (JP)
(74) Representative: D Young & Co LLP
(86) International application number: PCT/JP2020/036411
(87) International publication number: WO 2021/060519

(57) **Abstract**

There is provided a light-emitting device (1) including: a light-emitting element (20); a light-transmissive heat dissipation member (11) having a plate shape; a wavelength conversion member (12) that takes in, from a side of a light scattering layer (12a), light that is emitted from the light-emitting element (20) and passes through the light-transmissive heat dissipation member (11), and converts a wavelength in a fluorescent layer (12b); a lateral heat dissipation member that has a plate shape, includes a high-heat conduction member (13) in contact with a side surface of the wavelength conversion member (12) via a light reflection member (14), and is in contact with an upper surface of the light-transmissive heat dissipation member (11); and a package (21) that houses the light-emitting element (20) and supports a wavelength conversion unit (100) including the light-transmissive heat dissipation member (11), the wavelength conversion member (12), and the lateral heat dissipation member.

## Description

### Technical Field

The present invention relates to a light-emitting device, a wavelength conversion unit, and a headlight or a display apparatus.

### Background Art

As an existing light-emitting device, a light-emitting device including a semiconductor laser element, a support that is disposed above the semiconductor laser element and has a through hole through which light emitted from the semiconductor laser element passes, a fluorescent member that is disposed in the through hole and contains a fluorophore that is excited by the emitted light of the semiconductor laser element and emits light having a wavelength different from that of the emitted light, and a light-transmissive heat dissipation member bonded to a lower surface of the fluorescent member and the support has been known (see Patent Literature 1).

In accordance with Patent Literature 1, by providing a heat dissipation path for indirectly releasing the heat of the fluorescent member to the heat dissipation member via the support in addition to a heat dissipation path for directly releasing the heat of the fluorescent member to the heat dissipation member, the heat dissipation of the fluorescent member is improved.

Further, as another existing light-emitting device, a light-emitting device having a CAN type package, which includes a stem, a semiconductor laser, a case part, and a wavelength conversion member, has been known (see Patent Literature 2). The wavelength conversion member has a wavelength-conversion region containing a fluorophore material and a holding region for holding it, and is fixed in an opening provided in the center of the top surface of the case part.

In accordance with Patent Literature 2, the heat generated by the fluorophore in the wavelength-conversion region is transferred to the case part via the holding region and dissipated.

### Citation List

### Patent Literature

Patent Literature 1: Japanese Patent Application Laid-open No. 2017-216362
Patent Literature 2: Japanese Patent Application Laid-open No. 2018-2912

### Disclosure of Invention

### Technical Problem

However, in order to effectively suppress the temperature rise of the wavelength conversion member containing a fluorophore, it is desired to not only improve the heat dissipation of the wavelength conversion member as in the light-emitting device in Patent Literature 1 or Patent Literature 2 but also suppress the heat generation of the wavelength conversion member.

It is an object of the present invention to provide a light-emitting device having a structure capable of suppressing the amount of heat generated by the wavelength conversion member and effectively releasing the heat of the wavelength conversion member to suppress the temperature quenching of the fluorophore, a wavelength conversion unit constituting the light-emitting device, and a headlight or a display apparatus including the light-emitting device or the wavelength conversion unit.

### Solution to Problem

In order to achieve the above-mentioned object, an aspect of the present invention provides the following light-emitting device according to [1] to [13], the wavelength conversion unit according to [14] to [18], and the headlight or a display apparatus according to [19] and [20].
[1] A light-emitting device, including: a light-emitting element; a light-transmissive heat dissipation member having a plate shape, light that is emitted from the light-emitting element passing through the light-transmissive heat dissipation member; a wavelength conversion member that includes a laminated layer of a light scattering layer and a fluorescent layer, takes in, from a side of the light scattering layer, light that is emitted from the light-emitting element and passes through the light-transmissive heat dissipation member, and converts a wavelength in the fluorescent layer; a lateral heat dissipation member that has a plate shape, includes a high-heat conduction member in contact with a side surface of the wavelength conversion member via a light reflection member, and is in contact with an upper surface of the light-transmissive heat dissipation member; and a package that houses the light-emitting element and supports a wavelength conversion unit including the light-transmissive heat dissipation member, the wavelength conversion member, and the lateral heat dissipation member.
[2] The light-emitting device according to [1] above, in which a thickness of the light scattering layer is within a range of 50 µm or more and 200 µm or less.
[3] The light-emitting device according to [1] above, in which a thickness of the fluorescent layer is within a range of 50 µm or more and 100 µm or less.
[4] The light-emitting device according to [1] above, in which the light scattering layer is formed of a material obtained by removing an activator of the fluorophore contained in the fluorescent layer from a material of the fluorescent layer.
[5] The light-emitting device according to [1] above, in which the package is bonded to the light-transmissive heat dissipation member and the high-heat conduction member.
[6] The light-emitting device according to [1] above, in which a space inside the package in which the light-emitting element is housed is hermetically sealed by the package and the wavelength conversion unit.
[7] The light-emitting device according to [1] above, in which part or whole of a side surface of the wavelength conversion member on a side of the light-transmissive heat dissipation member has an inclined surface such that a width of the wavelength conversion member is narrowed toward the light-transmissive heat dissipation member.
[8] The light-emitting device according to [1] above, in which the inclined surface and the upper surface of the light-transmissive heat dissipation member are adhered by a light-reflecting adhesive material.
[9] The light-emitting device according to [1] above, in which the lateral heat dissipation member includes a heat dissipation member that has a plate shape, is in contact with the upper surface of the light-transmissive heat dissipation member and a lower surface of the high-heat conduction member, and is in contact with a side surface of the wavelength conversion member directly or via a light reflector, thermal conductivity of the high-heat conduction member is higher than thermal conductivity of the heat dissipation member, and the thermal conductivity of the heat dissipation member is higher than thermal conductivity of the light-transmissive heat dissipation member.
[10] The light-emitting device according to [9] above, in which the heat dissipation member has, in a side portion on a side of the wavelength conversion member, a recessed portion for providing a gap between the heat dissipation member and the side surface of the wavelength conversion member.
[11] The light-emitting device according to [10] above, in which a light reflection member is provided in the gap.
[12] The light-emitting device according to [1] above, in which an inside of the package is hermetically sealed by a seal member sandwiched between the high-heat conduction member and the package.
[13] The light-emitting device according to [1], which is used for a headlight or a display apparatus.
[14] A wavelength conversion unit, including: a wavelength conversion member in which a fluorescent layer containing a fluorophore and a light scattering layer for scattering excitation light of the fluorophore are laminated; a light-transmissive heat dissipation member that has a plate shape and is in contact with a surface of the light scattering layer of the wavelength conversion member, the excitation light passing through the light-transmissive heat dissipation member; and a lateral heat dissipation member that includes a high-heat conduction member that is in contact with a side surface of the wavelength conversion member via a light reflection member and is in contact with an upper surface of the light-transmissive heat dissipation member, wherein thermal conductivity of the light-transmissive heat dissipation member is higher than thermal conductivity of the wavelength conversion member, and thermal conductivity of the high-heat conduction member is higher than the thermal conductivity of the light-transmissive heat dissipation member.
[15] The wavelength conversion unit according to [14] above, in which a thickness of the light scattering layer is within a range of 50 µm or more and 200 µm or less.
[16] The wavelength conversion unit according to [14] above, in which a thickness of the fluorescent layer is within a range of 50 µm or more and 100 µm or less.
[17] The wavelength conversion unit according to [14] above, in which the light scattering layer is formed of a material obtained by removing an activator of the fluorophore contained in the fluorescent layer from a material of the fluorescent layer.
[18] The wavelength conversion unit according to [14] above, which is used for a headlight or a display apparatus.
[19] A headlight or a display apparatus including the light-emitting device according to [1] above.
[20] A headlight or a display apparatus including the wavelength conversion unit according to [14] above. Advantageous Effects of Invention

In accordance with the present invention, it is possible to provide a light-emitting device having a structure capable of suppressing the amount of heat generated by the wavelength conversion member and effectively releasing the heat of the wavelength conversion member to suppress the temperature quenching of the fluorophore, a wavelength conversion unit constituting the light-emitting device, and a headlight or a display apparatus including the light-emitting device or the wavelength conversion unit.

### Brief Description of Drawings

[Fig. 1] Fig. 1 is a vertical cross-sectional view of a light-emitting device according to a first embodiment.
[Fig. 2A]Fig. 2A is a diagram schematically showing the distribution of heat inside a wavelength conversion member in the case where the wavelength conversion member includes a laminate of a light scattering layer and a fluorescent layer.
[Fig. 2B] Fig. 2B is a diagram schematically showing the distribution of heat inside a wavelength conversion member in the case where the wavelength conversion member includes only a fluorescent layer.
[Fig. 3] Fig. 3 is a perspective view of an example of the wavelength conversion unit according to the first embodiment.
[Fig. 4] Fig. 4 is a vertical cross-sectional view of a modified example of the light-emitting device according to the first embodiment.
[Fig. 5A] Fig. 5A is an enlarged view of the periphery of a wavelength conversion member according to a modified example of the light-emitting device according to the first embodiment.
[Fig. 5B] Fig. 5B is an enlarged view of the periphery of a wavelength conversion member according to another modified example of the light-emitting device according to the first embodiment.
[Fig. 5C] Fig. 5C is an enlarged view of the periphery of a wavelength conversion member according to another modified example of the light-emitting device according to the first embodiment.
[Fig. 6] Fig. 6 is a vertical cross-sectional view of a light-emitting device according to a second embodiment.
[Fig. 7] Fig. 7 is a perspective view of an example of a wavelength conversion unit according to the second embodiment.
[Fig. 8A] Fig. 8A is an enlarged view of the periphery of a wavelength conversion member according to a modified example of the light-emitting device according to the second embodiment.
[Fig. 8B] Fig. 8B is an enlarged view of the periphery of a wavelength conversion member according to another modified example of the light-emitting device according to the second embodiment.
[Fig. 9A] Fig. 9A is an enlarged view of the periphery of a wavelength conversion member according to another modified example of the light-emitting device according to the second embodiment.
[Fig. 9B] Fig 9B is an enlarged view of the periphery of a wavelength conversion member according to another modified example of the light-emitting device according to the second embodiment.
[Fig. 9C] Fig. 9C is an enlarged view of the periphery of a wavelength conversion member according to another modified example of the light-emitting device according to the second embodiment.
[Fig. 10] Fig. 10 is a vertical cross-sectional view of a light-emitting device according to a third embodiment.
[Fig. 11A] Fig. 11A shows the temperature distribution of a light scattering layer in the case where laser light is uniformly applied to the surface of the light scattering layer.
[Fig. 11B] Fig. 11B shows the temperature distribution of the light scattering layer in the case where laser light is applied intensively to the vicinity of the center of the surface of the light scattering layer.
[Fig. 12A] Fig. 12A is a graph showing a relationship between the thickness of the fluorescent layer and the temperature of the fluorescent layer when laser light has been applied thereto.
[Fig. 12B] Fig. 12B is a graph showing a relationship between the thickness of the fluorescent layer and the brightness of the light extracted from the wavelength conversion member.
[Fig. 13A] Fig. 13A is a graph showing a relationship between the thickness of the light scattering layer and the temperature of the fluorescent layer when laser light has been applied thereto.
[Fig. 13B] Fig. 13B is graph showing a relationship between the thickness of the light scattering layer and the brightness of the light extracted from the wavelength conversion member.
[Fig. 14A] Fig. 14A shows a relationship between the angle of the light extracted from the wavelength conversion member and a chromaticity coordinate Cy of the CIE1931 chromaticity diagram.
[Fig. 14B] Fig. 14B shows a relationship between the angle of the light extracted from the wavelength conversion member and the chromaticity coordinate Cy of the CIE1931 chromaticity diagram.
[Fig. 14C] Fig. 14C shows a relationship between the angle of the light extracted from the wavelength conversion member and the chromaticity coordinate Cy of the CIE1931 chromaticity diagram. Mode(s) for Carrying Out the Invention

### (first embodiment)

### (Configuration of light-emitting device)

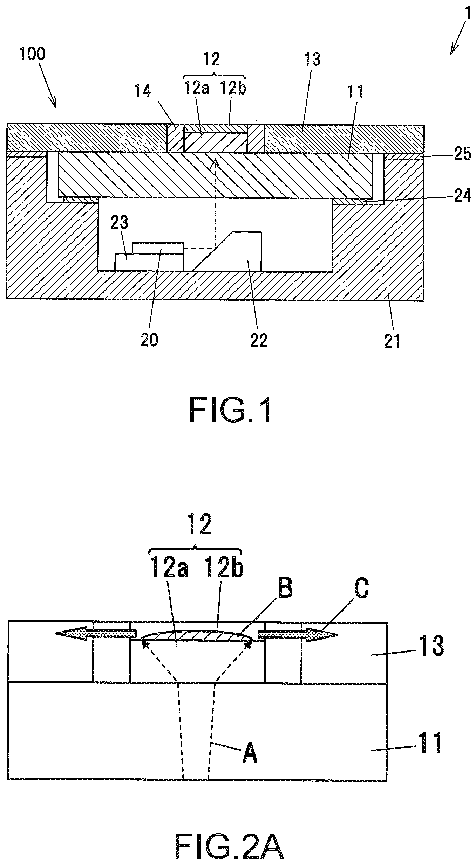

Fig. 1 is a vertical cross-sectional view of a light-emitting device 1 according to a first embodiment. The light-emitting device 1 includes: a light-emitting element 20; a light-transmissive heat dissipation member 11 having a plate shape, light that is emitted from the light-emitting element 20 passing through the light-transmissive heat dissipation member 11; a wavelength conversion member 12 that includes a laminated layer of a light scattering layer 12a and a fluorescent layer 12b, takes in, from a side of the light scattering layer 12a, light that is emitted from the light-emitting element 20 and passes through the light-transmissive heat dissipation member 11, and converts a wavelength in the fluorescent layer 12b; a high-heat conduction member 13 in contact with a side surface of the wavelength conversion member 12 via a light reflection member 14; and a package 21 that houses the light-emitting element 20.

The high-heat conduction member 13 and the light reflection member 14 constitute a lateral heat dissipation member for releasing the heat of the wavelength conversion member 12 to the lateral side, which has a plate shape and is in contact with the upper surface of the light-transmissive heat dissipation member 11.

The light-transmissive heat dissipation member 11, the wavelength conversion member 12, the high-heat conduction member 13, and the light reflection member 14 constitute a wavelength conversion unit 100, and the wavelength conversion unit 100 is supported by the package 21. The light-emitting device 1 can be formed by attaching the wavelength conversion unit 100 to the opening of the package 21 in which the light-emitting element 20 and the like are housed.

Further, in the light-emitting device 1, the thermal conductivity of the light-transmissive heat dissipation member 11 is favorably higher than the thermal conductivity of the wavelength conversion member 12. Further, the thermal conductivity of the high-heat conduction member 13 is favorably higher than the thermal conductivity of the light-transmissive heat dissipation member 11.

The fluorescent layer 12b constituting the wavelength conversion member 12 is a layer containing a fluorophore that absorbs light (excitation light) emitted from the light-emitting element 20 and emits fluorescence. The fluorescent layer 12b is, for example, a member in which fluorophore particles are contained in a base material formed of alumina, glass, a resin, or the like, or a sintered body of a fluorophore.

The fluorophore contained in the fluorescent layer 12b is not particularly limited. For example, a yellowish fluorophore such as a YAG (yttrium·aluminum·garnet) fluorophore, an α- SiAlON fluorophore, and a BOS (barium·orthosilicate) fluorophore may be used, or these yellowish fluorophores may be mixed with a green fluorophore such as a β- SiAlON fluorophore and a red fluorophore such as (Ca,Sr)₂Si₅N₈:Eu and CaAlSiN₃:Eu and used.

The light scattering layer 12a constituting the wavelength conversion member 12 is capable of scattering the light emitted from the light-emitting element 20 (excitation light of the fluorophore contained in the fluorescent layer 12b) before reaching the fluorescent layer 12b to reduce viewing angle dependency of the light emitted from the light-emitting device 1. The light scattering layer 12a contains no fluorophore.

For example, in the case where the fluorescent layer 12b includes a sintered body of a fluorophore, a material obtained by removing the activator (impurity that is the center of light emission) of the fluorophore contained in the fluorescent layer 12b from the material of the fluorescent layer 12b can be used as the material of the light scattering layer 12a. Specifically, for example, in the case where the fluorescent layer 12b includes a sintered body of a YAG fluorophore having Ce as an activator and alumina, a sintered body of YAG containing no Ce and alumina can be used as the material of the light scattering layer 12a.

Further, the wavelength conversion member 12 may be one obtained by bonding the light scattering layer 12a formed of a transparent scattering material such as alumina and the fluorescent layer 12b to each other.

In the formation of the wavelength conversion member 12, green sheets (sheets having flexibility before sintering) of the light scattering layer 12a and the fluorescent layer 12b can be sintered in a bonded state to be integrated. In the case where the material obtained by removing an activator from the fluorophore constituting the fluorescent layer 12b is used as the material of the light scattering layer 12a, it is possible to suppress deformation and breakage due to the difference in linear expansion coefficient because the linear expansion coefficient of the light scattering layer 12a and the fluorescent layer 12b are equal to each other. Further, the activator diffuses from the fluorescent layer 12b to the light scattering layer 12a to generate concentration gradation, and the interface between the fluorescent layer 12b and the light scattering layer 12a disappears. As a result, it is possible to suppress the generation of light (return light) returning from the wavelength conversion member 12 to the side of the light-emitting element 20 due to reflection at the interface between the fluorescent layer 12b and the light scattering layer 12a.

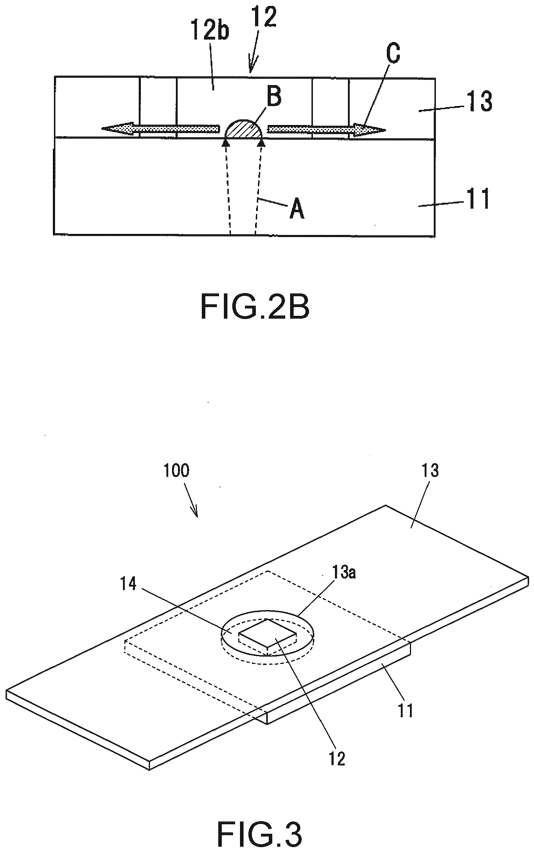

Fig. 2A and Fig. 2B are respectively diagrams schematically showing the distribution of heat inside the wavelength conversion member 12 in the case where the wavelength conversion member 12 includes a laminate of the light scattering layer 12a and the fluorescent layer 12b and in the case where the wavelength conversion member 12 includes only the fluorescent layer 12b.

Arrows A in Fig. 2A and Fig. 2B schematically represent the path of light emitted from the light-emitting element 20. A heat generation region B inside the wavelength conversion member 12 schematically represents a region in which the amount of heat generation is particularly large, of regions in which the fluorophore absorbs light and generates heat. Further, arrows C schematically represent the path of heat transferred from the heat generation region B to the high-heat conduction member 13 that is a member in which the thermal conductivity is particularly high.

In the case where the wavelength conversion member 12 includes a laminate of the light scattering layer 12a and the fluorescent layer 12b, as shown in Fig. 2A, the light that has passed through the light-transmissive heat dissipation member 11 diffuses in the light scattering layer 12a and then enters the fluorescent layer 12b. For this reason, light is absorbed in a relatively large range of the fluorescent layer 12b and the amount of heat generation per unit volume in the heat generation region B is reduced. Further, since the heat generation region B is relatively large, the distance to the high-heat conduction member 13 is small and heat can be efficiently released to the high-heat conduction member 13.

Meanwhile, in the case where the wavelength conversion member 12 includes only the fluorescent layer 12b, as shown in Fig. 2B, the light that has passed through the light-transmissive heat dissipation member 11 is absorbed by the fluorescent layer 12b as it is. For this reason, light is absorbed in a relatively wide range of the fluorescent layer 12b and the amount of heat generation per unit volume in the heat generation region B increases. Further, since the heat generation region B is relatively small, the distance to the high-heat conduction member 13 is large and it is difficult to efficiently release the heat to the high-heat conduction member 13.

For the reason described above, by forming the wavelength conversion member 12 of a laminate of the light scattering layer 12a and the fluorescent layer 12b, it is possible to suppress the temperature rise of the fluorescent layer 12b and suppress the temperature quenching.

The thicker the light scattering layer 12a, the lower the temperature of the fluorescent layer 12b. Meanwhile, the brightness of the extracted light tends to decrease. The thickness of the light scattering layer 12a is favorably, for example, within a range of 50 µm or more and 200 µm or less.

Further, the thicker the fluorescent layer 12b, the lower the temperature of the fluorescent layer 12b. Meanwhile, the brightness of the extracted light tends to decrease. The thickness of the fluorescent layer 12b is favorably, for example, within a range of 50 µm or more and 100 µm or less.

The planar shape of the wavelength conversion member 12 is typically a quadrangle, but may be a circle or a polygon other than the quadrangle. The wavelength conversion member 12 is adhered to the upper surface of the light-transmissive heat dissipation member 11 by, for example, a transparent adhesive (not shown) such as a silicone-based adhesive.

The light-emitting element 20 functions as an excitation light source for the fluorophore contained in the fluorescent layer 12b. The light-emitting element 20 is mounted on the package 21 while being placed on a pedestal 23. The light emitted from the light-emitting element 20 is reflected by a light reflection member 22 such as a mirror and then passes through the light-transmissive heat dissipation member 11 to enter the wavelength conversion member 12. Note that the light emitted from the light-emitting element 20 may be directly applied to the light-transmissive heat dissipation member 11 without using the light reflection member 22. The light-emitting device 1 may include a plurality of light-emitting elements 20 or a plurality of light reflection members 22.

The light-emitting element 20 is an LD (laser diode) or an LED (light-emitting diode). The effect of suppressing the temperature rise of the fluorescent layer 12b of the light-emitting device 1 is particularly important in the case where an LD having a large output is used as the light-emitting element 20.

The mission wavelength of the light-emitting element 20 is not particularly limited and is appropriately selected in accordance with the material (absorption wavelength) of the fluorescent layer 12b, the color of the light extracted from the light-emitting device 1, or the like. For example, in the case where the light-emitting element 20 emits blue light and the fluorescent layer 12b emits yellow fluorescence, white light that is mixed light of the blue light extracted without being wavelength-converted in the fluorescent layer 12b and the yellow fluorescence can be extracted from the light-emitting device 1.

The light-transmissive heat dissipation member 11 is formed of a material having a plate shape, through which light emitted from the light-emitting element 20 passes, such as sapphire. The light emitted from the light-emitting element 20 passes through the light-transmissive heat dissipation member 11 to enter the wavelength conversion member 12.

The upper surface of the light-transmissive heat dissipation member 11 is in contact with the lower surface of the wavelength conversion member 12, and is capable of releasing the heat generated in the fluorescent layer 12b of the wavelength conversion member 12 to the light-transmissive heat dissipation member 11.

The high-heat conduction member 13 is a member that has a plate shape and has thermal conductivity higher than that of the light-transmissive heat dissipation member 11. For example, a heat dissipation sheet or a metal plate can be used as the high-heat conduction member 13. As the metal plate, for example, those formed of SUS(stainless steel), Cu, or Al can be used. Further, in order to reduce the difference in thermal expansion coefficient from those of the light-transmissive heat dissipation member 1 and the package 21, clad materials such as CMC(Cu/Mo/Cu laminate) and a Cu/AlN/Cu laminate or impregnated carbon can be used as the material of the metal plate. Further, a material having anisotropic heat conduction properties, such as a graphite sheet, can be used as the high-heat conduction member 13 to improve the thermal conductivity in the in-plane direction.

The high-heat conduction member 13 is in contact with the side surface of the wavelength conversion member 12 via the light reflection member 14 and is capable of releasing the heat generated in the fluorescent layer 12b of the wavelength conversion member 12 to the high-heat conduction member 13. Further, the high-heat conduction member 13 is also capable of releasing, further to the high-heat conduction member 13, the heat transferred from the wavelength conversion member 12 to the light-transmissive heat dissipation member 11.

The light reflection member 14 is in contact with the side surface of the wavelength conversion member 12 and is capable of preventing light from leaking from the side surface of the wavelength conversion member 12 and improving the light extraction efficiency. The light reflection member 14 is formed of, for example, a material obtained by adding a reflective filler such as alumina, TiO, and BN to a base material formed of glass, a silicone resin, or the like. The higher the thermal conductivity of the light reflection member 14, the better.

The package 21 is favorably formed of a material through which the light emitted from the light-emitting element 20 and the light that has been wavelength-converted by the wavelength conversion member 12 do not pass, which has excellent thermal conductivity, such as AlN, alumina, Si, and Si₃N₄.

The package 21 is thermally bonded to the light-transmissive heat dissipation member 11 via an adhesive material 24. The thermally bonding means bonding with no heat-insulating layer having low thermal conductivity, such as an air layer. For this reason, the heat released from the fluorescent layer 12b of the wavelength conversion member 12 to the light-transmissive heat dissipation member 11 can be further released to the package 21. The adhesive material 24 is formed of, for example, solder, a sintered metal such as Ag and Cu, or glass frit, and is favorably formed of, particularly, AuSn solder having excellent thermal conductivity, solder using Cu as a base material, or the like.

Further, the package 21 is bonded to the high-heat conduction member 13 via an adhesive material 25. For this reason, the heat released from the fluorescent layer 12b of the wavelength conversion member 12 to the high-heat conduction member 13 can be further released to the package 21. The adhesive material 25 is formed of, for example, an adhesive, an adhesive sheet, or solder, and is favorably formed of, particularly, AuSn solder having excellent thermal conductivity, solder using Cu as a base material, or the like.

In the light-emitting device 1, a space inside the package 21 in which the light-emitting element 20 and the light reflection member 22 are housed can be hermetically sealed by the package 21 and the wavelength conversion unit 100. This hermetically sealing makes it possible to suppress contamination of the light-emitting element 20 and the light reflection member 22 due to water and siloxane gas generated from the resin member.

Specifically, the adhesive material 24 has an annular shape and bonds the package 21 and the light-transmissive heat dissipation member 11 to each other without gaps, making it possible to hermetically sealing, by the package 21, the light-transmissive heat dissipation member 11, and the adhesive material 24, the space inside the package 21 in which the light-emitting element 20 and the light reflection member 22 are housed.

Further, by bonding the package 21 and the high-heat conduction member 13 to each other without gaps by the adhesive material 25, it is possible to doubly and hermetically seal the space in which the light-emitting element 20 is housed and more effectively suppress the contamination of the light-emitting element 20 and the light reflection member 22.

The height of the upper surface of the wavelength conversion member 12 is favorably equal to or higher than the height of the upper surface of the high-heat conduction member 13. Typically, it is favorable that the height of the upper surface of the wavelength conversion member 12 and the height of the upper surface of the high-heat conduction member 13 are substantially equal to each other, forming substantially the same surface. This is because, for example, in the case where a lens is placed on the light-emitting device 1 to collect the light emitted from the light-emitting device 1, the loss of light due to being blocked by the high-heat conduction member 13 is suppressed. Further, there is also a problem that in the case where the upper surface of the wavelength conversion member 12 is lower than the upper surface of the high-heat conduction member 13, the lens cannot be brought close to the light-emitting surface of the wavelength conversion member 12 and light loss occurs.

Fig. 3 is a perspective view of an example of the wavelength conversion unit 100. The high-heat conduction member 13 is laminated on the light-transmissive heat dissipation member 11, and the wavelength conversion member 12 is placed in a hole 13a of the high-heat conduction member 13. Either the high-heat conduction member 13 and the wavelength conversion member 12 may be fixed onto the light-transmissive heat dissipation member 11 first. After fixing the high-heat conduction member 13 and the wavelength conversion member 12 onto the light-transmissive heat dissipation member 11, a slurry material of the light reflection member 14 is poured into the space around the wavelength conversion member 12 in the hole 13a and the material is sintered to form the light reflection member 14. Note that the planar shape of the hole 13a is a circular shape in the example shown in Fig. 3, but may be a rectangular shape. By making the planar shape of the hole 13a rectangular, it is possible to further improve the heat releasing performance by the high-heat conduction member 13 from the light-transmissive heat dissipation member 11 and the wavelength conversion member 12.

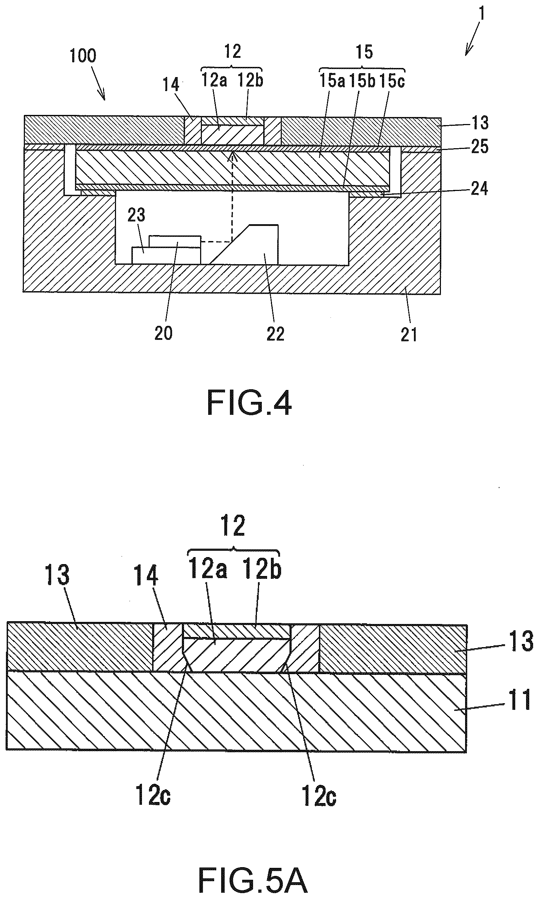

Fig. 4 is a vertical cross-sectional view of a modified example of the light-emitting device 1. As shown in Fig. 4, instead of the light-transmissive heat dissipation member 11, a light-transmissive heat dissipation member 15 in which an AR (Anti-Reflection) film 15b and a DBR (Distributed Bragg Reflector) film 15c are respectively provided on the lower surface and the upper surface of a base material 15a having a plate shape (corresponding to the light-transmissive heat dissipation member 11) may be used.

The AR film 15b is capable of suppressing the reflection of light emitted from the light-emitting element 20 on the lower surface of the light-transmissive heat dissipation member 15. The AR film 15b may be a periodic structure such as a nanoimprint. Further, the DBR film 15c has a property of transmitting the light emitted from the light-emitting element 20 therethrough and reflecting the fluorescence emitted from the fluorescent layer 12b of the wavelength conversion member 12. By using the AR film 15b and the DBR film 15c, it is possible to improve the light extraction efficiency of the light-emitting device 1. Note that in the light-transmissive heat dissipation member 15, only one of the AR film 15b and the DBR film 15c may be used.

The AR film 15b and the DBR film 15c are provided on a mirror-processed smooth surface of the base material 15a in order to fully exert the functions thereof.

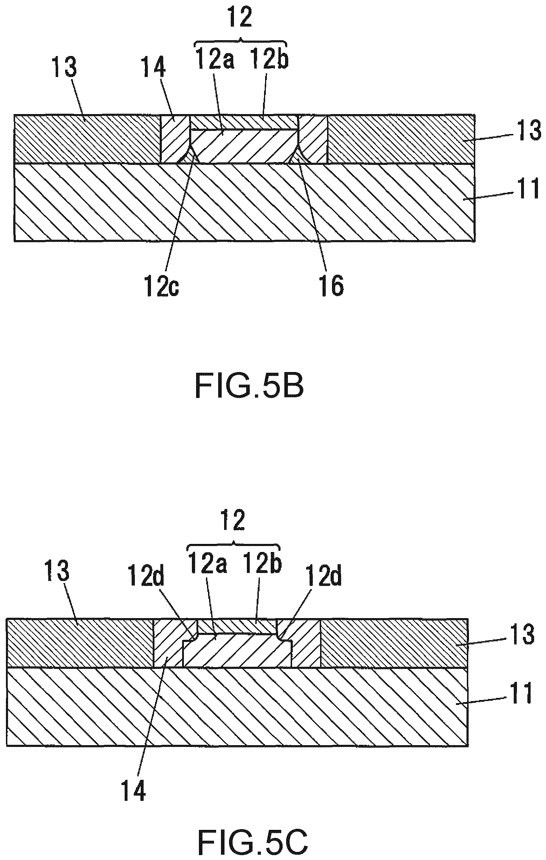

Fig. 5A, Fig. 5B, and Fig. 5C are each an enlarged view of the periphery of the wavelength conversion member 12 according to a modified example of the light-emitting device 1.

As shown in Fig. 5A, the wavelength conversion member 12 may have a tapered shape in which part or whole on the lower side is tapered toward the lower side (the side of the light-transmissive heat dissipation member 11). That is, part or whole on the lower side of the side surface of the wavelength conversion member 12 may have an inclined surface 12c such that the width of the wavelength conversion member 12 is narrowed toward the lower side.

In this case, it is possible to reflect, by the inclined surface 12c, light traveling downward through the wavelength conversion member 12 to reduce the return light from the wavelength conversion member 12 to the side of the light-emitting element 20. As a result, it is possible to improve the light extraction efficiency of the light-emitting device 1. Further, by providing the inclined surface 12c, the contact area with the light reflection member 14 increases as compared with the case where the side surface is vertical, and therefore, the heat can be easily released to the high-heat conduction member 13 via the light reflection member 14.

Further, as shown in Fig. 5B, by using a light-reflecting adhesive material 16 obtained by adding a reflective filler such as TiO₂ and BN to an adhesive material such as a silicone-based adhesive material may be used to bond the inclined surface 12c of the wavelength conversion member 12 and the upper surface of the light-transmissive heat dissipation member 11 to each other. By using the light-reflecting adhesive material 16, it is possible to further reduce the return light from the wavelength conversion member 12.

Further, as shown in Fig. 5C, by providing, at the outer edge of the upper portion of the wavelength conversion member 12, a recess 12d whose bottom reaches the light scattering layer 12a, the width of the fluorescent layer 12b may be reduced to be smaller than the width of the light scattering layer 12a. As a result, the heat from the fluorescent layer 12b is transferred to the light scattering layer 12a while spreading, and the contact area between the light scattering layer 12a and the light-transmissive heat dissipation member 11 with respect to the area of the fluorescent layer 12b increases, improving the heat dissipation. Further, since the light reflection member 14 enters the recess 12d, the wavelength conversion member 12 is prevented from peeling of and the reliability of the light-emitting device 1 is improved.

### (Second embodiment)

A light-emitting device 2 according to a second embodiment is different from the light-emitting device 1 according to the first embodiment in that the light-emitting device 2 further includes a heat dissipation member 17 described below. Note that members similar to those of the first embodiment will be denoted by the same reference symbols and description thereof will be omitted or simplified.

### (Configuration of light-emitting device)

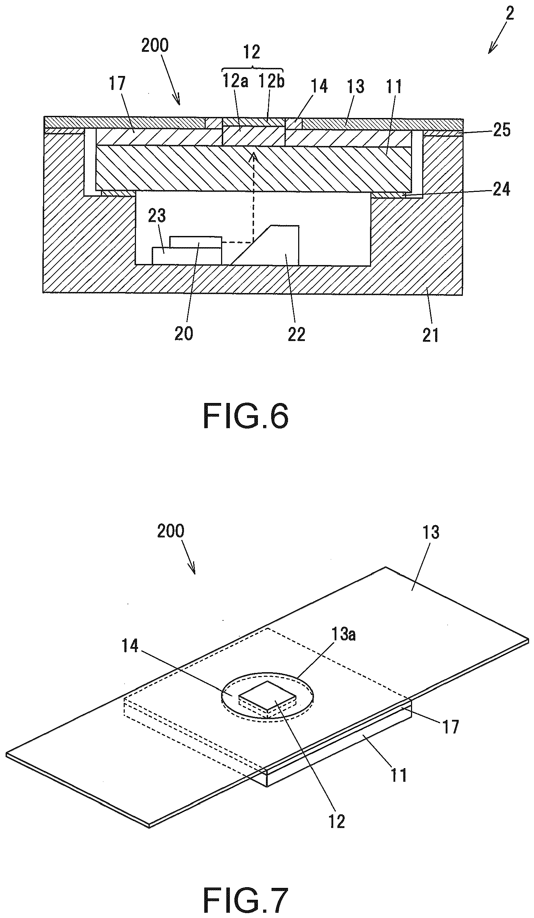

Fig. 6 is a vertical cross-sectional view of the light-emitting device 2 according to the second embodiment. The light-emitting device 2 includes the heat dissipation member17 having a plate shape between the light-transmissive heat dissipation member 11 and the high-heat conduction member 13. The side surface, the upper surface, and the lower surface of the heat dissipation member 17 are respectively in contact with the side surface of the wavelength conversion member 12, the lower surface of the high-heat conduction member 13, and the upper surface of the light-transmissive heat dissipation member 11.

The conductivity of the heat dissipation member 17 is higher than the conductivity of the light-transmissive heat dissipation member 11, and the conductivity of the high-heat conduction member 13 is higher than the conductivity of the heat dissipation member 17. As the heat dissipation member 17, for example, alumina, aluminum nitride, copper, or aluminum can be used.

The heat transferred from the wavelength conversion member 12 to the heat dissipation member 17 can be released to the high-heat conduction member 13. The light-emitting device 2 including the heat dissipation member 17 is superior in heat dissipation of the fluorescent layer 12b of the wavelength conversion member 12 as compared with the light-emitting device 1 that does not include the heat dissipation member 17. This is presumably because the heat can be directly radiated from the side surface of the wavelength conversion member 12 to the heat dissipation member 17 and therefore, the heat dissipation area increases.

The high-heat conduction member 13, the light reflection member 14, and the heat dissipation member 17 constitute a lateral heat dissipation member for releasing the heat of the wavelength conversion member 12 to the lateral side, which has a plat shape and is in contact with the upper surface of the light-transmissive heat dissipation member 11.

The light-transmissive heat dissipation member 11, the wavelength conversion member 12, the high-heat conduction member 13, the light reflection member 14, and the heat dissipation member 17 constitute a wavelength conversion unit 200, and the wavelength conversion unit 200 is supported by the package 21. By attaching the wavelength conversion unit 200 to the opening of the package 21 in which the light-emitting element 20 and the like are housed, the light-emitting device 2 can be formed.

Similarly to the light-emitting device 1 according to the first embodiment, the light-emitting device 2 may use the light-transmissive heat dissipation member 15 including one or both of the AR film 15b and the DBR film 15c instead of the light-transmissive heat dissipation member 11.

Fig. 7 is a perspective view of an example of the wavelength conversion unit 200. The wavelength conversion member 12 is fitted into, for example, a hole of the heat dissipation member 17, which has a shape into which the wavelength conversion member 12 just fits. For example, in the case where the heat dissipation member 17 is formed of ceramic, by embedding the wavelength conversion member 12 in the green sheet of the heat dissipation member 17 and sintering it, the heat dissipation member 17 surrounding the wavelength conversion member 12 can be formed.

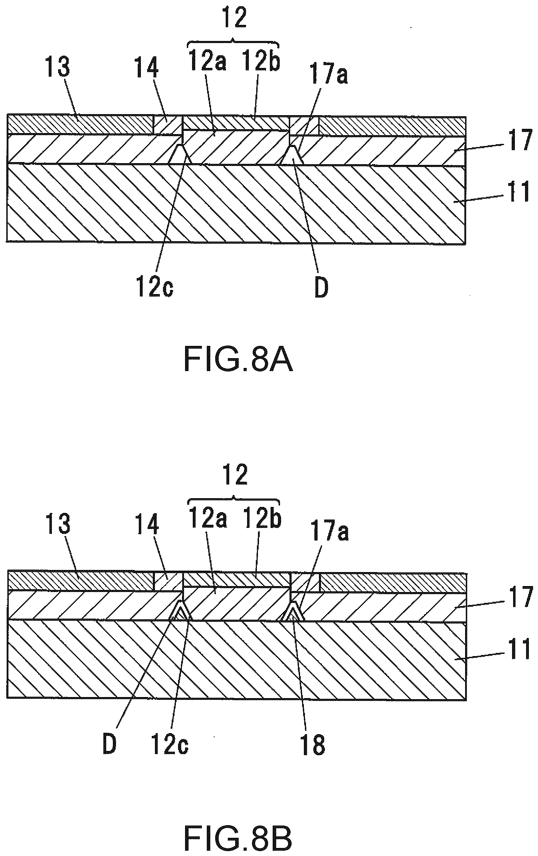

Fig. 8A and Fig. 8B are each an enlarged view of the periphery of the wavelength conversion member 12 according to a modified example of the light-emitting device 2.

As shown in Fig. 8A, a recessed portion 17a for providing a gap D between the heat dissipation member 17 and the side surface of the wavelength conversion member 12 may be formed in a side portion of the heat dissipation member 17 on the side of the wavelength conversion member 12. Since the refractive index of the air in the gap D is smaller than the refractive index of the wavelength conversion member 12, it is possible to improve the reflection efficiency of light on the side surface of the wavelength conversion member 12. Note that in order to cause an air layer to be adjacent to the side surface of the wavelength conversion member 12, it is required that an adhesive material (not shown) for adhering the wavelength conversion member 12 and the light-transmissive heat dissipation member 11 does not fill the gap D.

Further, as shown in Fig. 8A, by providing the inclined surface 12c on the wavelength conversion member 12 together with the recessed portion 17a of the wavelength conversion member 12, it is possible to further improve the reflection efficiency of light on the side surface of the wavelength conversion member 12.

Further, as shown in Fig. 8B, a light reflection member 18 such as a mirror may be provided in the gap D between the wavelength conversion member 12 and the heat dissipation member 17. Since the light leaked from the side surface of the wavelength conversion member 12 to the gap D can be reflected by the light reflection member 18 toward the wavelength conversion member 12, it is possible to further improve the light extraction efficiency of the light-emitting device 2. The light reflection member 18 may be separated from or in contact with the wavelength conversion member 12. Further, the light reflection member 18 may be bonded to the inclined surface 12c by a bonding material or the like.

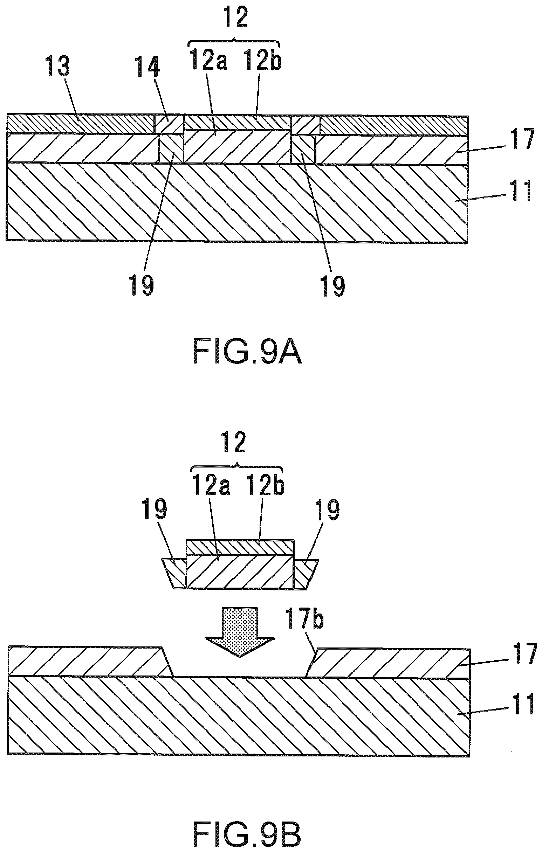

Fig. 9A to Fig. 9C are each an enlarged view of the periphery of the wavelength conversion member 12 according to another modified example of the light-emitting device 2.

As shown in Fig. 9A, a high-heat dissipation light reflector 19 may be provided between the wavelength conversion member 12 and the heat dissipation member 17. As a result, it is possible to improve the reflection efficiency of light on the side surface of the wavelength conversion member 12 and improve the light extraction efficiency of the light-emitting device 2. Meanwhile, since the thermal conductivity of the high-heat dissipation light reflector 19 is lower than the thermal conductivity of the heat dissipation member 17, it is possible to select whether or not to use the high-heat dissipation light reflector 19 depending on whether the light extraction efficiency of the light-emitting device 2 or the heat dissipation of the wavelength conversion member 12 is emphasized.

The high-heat dissipation light reflector 19 is formed of, for example, a material obtained by adding a reflective filler such as TiO₂ and BN to a bonding material formed of a transparent material such as SiO₂, glass, a silicone resin, and an epoxy resin. The thermal conductivity of the high-heat dissipation light reflector 19 is favorably 5 W/(m·K) or more.

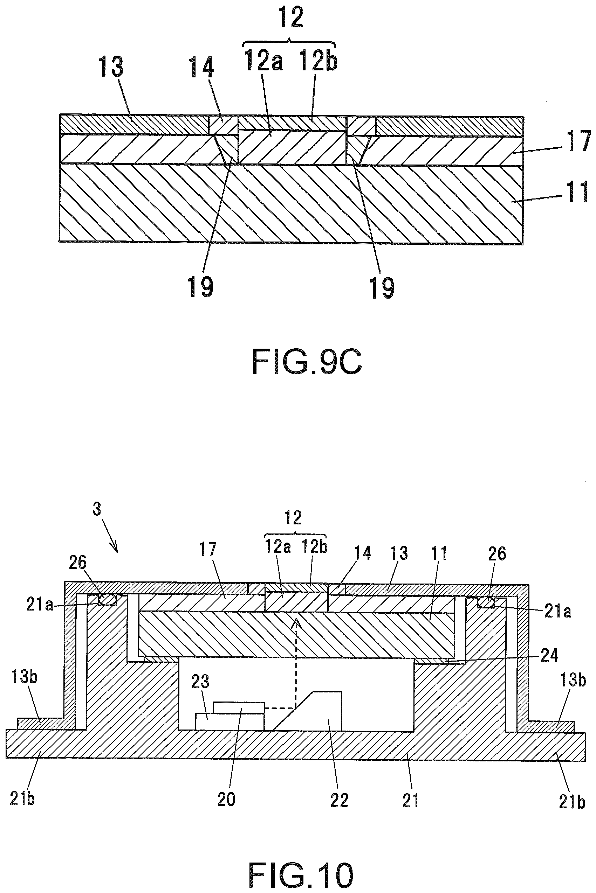

Further, as shown in Fig. 9B and Fig. 9C, after forming the high-heat dissipation light reflector 19 around the wavelength conversion member 12, this may be fitted into the heat dissipation member 17.

Fig. 9B is a schematic diagram showing how the wavelength conversion member 12 around which the high-heat dissipation light reflector 19 has been formed is fitted into a hole 17b of the heat dissipation member 17. Fig. 9C shows the state in which after fitting the wavelength conversion member 12 around which the high-heat dissipation light reflector 19 has been formed into the hole 17b of the heat dissipation member 17, the high-heat conduction member 13 and the light reflection member 14 are respectively formed on the heat dissipation member 17 and the high-heat dissipation light reflector 19.

As shown in Fig. 9B and Fig. 9C, the high-heat dissipation light reflector 19 around which the wavelength conversion member 12 has been formed has a tapered shape that tapers toward the lower side (the side of the light-transmissive heat dissipation member 11). Further, the hole 17b of the heat dissipation member 17 has a tapered shape corresponding to the tapered shape of the high-heat dissipation light reflector 19.

In this case, for example, by embedding the wavelength conversion member 12 in the green sheet of the high-heat dissipation light reflector 19, sintering it, and then cutting the high-heat dissipation light reflector 19 into a tapered shape, the wavelength conversion member 12 around which the high-heat dissipation light reflector 19 as shown in Fig. 9B has been formed can be formed.

### (Third embodiment)

A light-emitting device 3 according to a third embodiment is different from the light-emitting device 2 according to the second embodiment in that the light-emitting device 3 has a sealing structure in which a seal member is sandwiched between a high-heat conduction member and a package. Note that members similar to those of the second embodiment will be denoted by the same reference symbols and description thereof will be omitted or simplified.

### (Configuration of light-emitting device)

Fig. 10 is a vertical cross-sectional view of the light-emitting device 3 according to the third embodiment. In the light-emitting device 3, the high-heat conduction member 13 has a cup shape that covers the upper side and the lateral side of the package 21 and includes a fixing portion 13b for fixing to the package 21, which projects from the edge of the opening toward the outer peripheral side. Further, the high-heat conduction member 13 is formed of, for example, SUS, Cu, Al, CMC (Cu/Mo/Cu laminate), Cu/AlN/Cu laminate, or impregnated carbon. The package 21 incudes a recessed portion 21a for housing a seal member 26 and a fixed portion 21b for fixing the high-heat conduction member 13, which projects from the vicinity of the bottom portion toward the outer peripheral side.

The seal member 26 is, for example, an annular packing formed of a fluorine resin or the like, and exhibits the sealing function by being appropriately compressed in the thickness direction by the high-heat conduction member 13 and the package 21. The position of the seal member 26 is not particularly limited. As shown in Fig. 10, the seal member 26 is favorably provided at a position in contact with the top plate (plate-shaped portion covering the upper part of the package 21) of the high-heat conduction member 13.

The fixed portion 21b of the package 21 and the fixing portion 13b of the high-heat conduction member 13 are bonded to each other by, for example, welding, solder bonding, or caulking.

In the light-emitting device 2 according to the second embodiment, the height of the upper surface of the wavelength conversion member 12 and the height of the upper surface of the high-heat conduction member 13 do not match in some cases due to variations in the thickness of the light-transmissive heat dissipation member 11, the heat dissipation member 17, the adhesive material 24 within the tolerance. In the light-emitting device 3, by using the seal member 26, even in the case where the thicknesses of the light-transmissive heat dissipation member 11, the heat dissipation member 17, and the adhesive material 24 vary, it is possible to adjust the height of the upper surface of the high-heat conduction member 13 to match with the height of the upper surface of the wavelength conversion member 12. Further, by using the seal member 26, it is easy to achieve the airtightness inside the package 21 even in the case where the light-emitting device 3 has received vibration or the case where the high-heat conduction member 13 or the package 21 has received thermal stress.

### (Effects of embodiments)

In accordance with the light-emitting devices 1, 2, and 3 according to the first to third embodiments described above, since the amount of heat generated by the fluorescent layer 12b can be suppressed and the heat of the fluorescent layer 12b can be effectively released by the peripheral member of the wavelength conversion member 12 such as the high-heat conduction member 13 by using the light scattering layer 12a in the wavelength conversion member 12, it is possible to effectively suppress the temperature quenching of the fluorophore contained in the fluorescent layer 12b. The light-emitting devices 1, 2, and 3 and the wavelength conversion units 100 and 200 included therein are applicable to, for example, a light-source apparatus, a headlight, a display apparatus, and the like.

### Example 1

The relationship between the application state of laser light to the light scattering layer 12a and the temperature distribution was investigated by simulation. In this simulation, the thickness of the wavelength conversion member 12 was set to 200 µm and the thickness of the light scattering layer 12a was set to 150 µm.

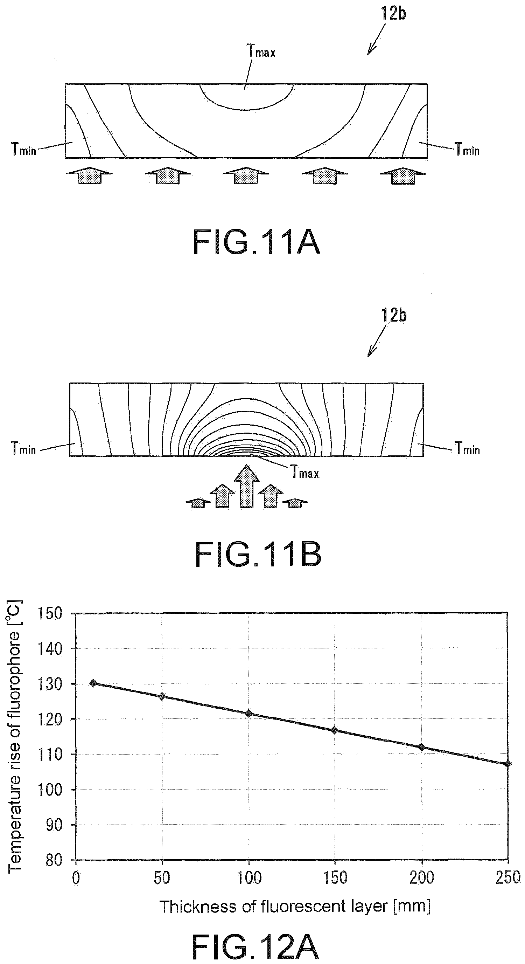

Fig. 11A shows the temperature distribution of the light scattering layer 12a in the case where laser light was uniformly applied to the surface of the light scattering layer 12a. Fig. 11B shows the temperature distribution of the light scattering layer 12a in the case where laser light was applied intensively to the vicinity of the center of the surface of the light scattering layer 12a.

The temperature of a region Tₘₐₓ whose temperature is the highest in the light scattering layer 12a in Fig. 11A was 100.9°C, the temperature of a region Tₘᵢₙ whose temperature is the lowest was 76.8°C, and the overall average temperature was 92.0°C.

The temperature of the region Tₘₐₓ whose temperature is the highest in the light scattering layer 12a in Fig. 11B was 16 7.8°C, the temperature of the region Tₘᵢₙ whose temperature is the lowest was 72.2°C, and the overall average temperature was 93.4°C.

In accordance with Fig. 11A and Fig. 11B, it is possible to more suppress the temperature rise by uniformly applying laser light to the surface of the light scattering layer 12a. This means that diffusing, in in the wavelength conversion member 12 of the light-emitting device 1, 2, the light emitted from the light-emitting element 20 by the light scattering layer 12a before reaching the fluorescent layer 12b is effective to suppress the temperature rise of the light scattering layer 12a.

### Example 2

The thicknesses of the light scattering layer 12a and the fluorescent layer 12b, the temperature of the fluorescent layer 12b, and the brightness of light extracted from the wavelength conversion member 12 when laser light was applied to the wavelength conversion member 12 were investigated by simulation.

In this simulation, the planar shape of the wavelength conversion member 12 was made a rectangular shape of 0.5 mm × 1.0 mm.

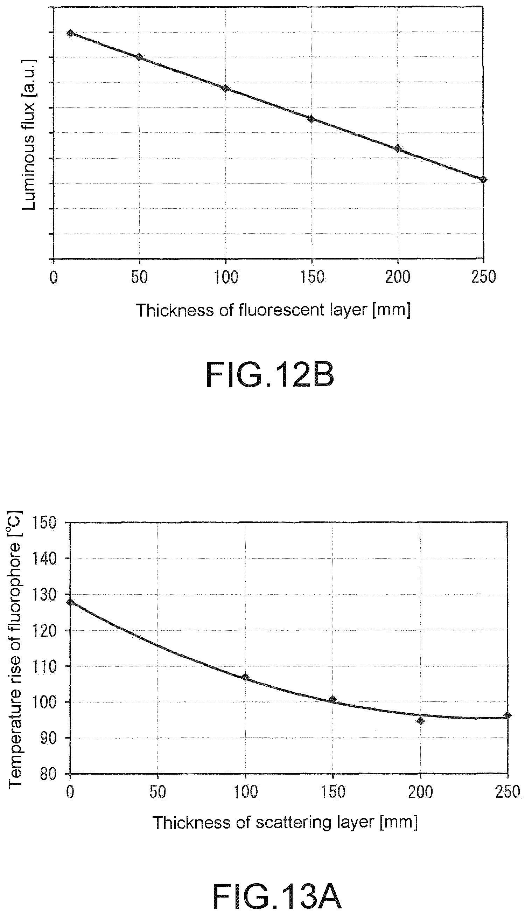

Fig. 12A is a graph showing the relationship between the thickness of the fluorescent layer 12b when the thickness of the light scattering layer 12a was fixed to 150 µm and the thickness of the fluorescent layer 12b was changed between 0 to 250 mm and the amount of increase in the temperature of the fluorescent layer 12b from room temperature (25°C) when laser light was applied thereto. Further, Fig. 12B is a graph showing the relationship between the thickness of the fluorescent layer 12b when the thickness of the light scattering layer 12a was fixed to 150 µm and the thickness of the fluorescent layer 12b was changed between 0 to 250 mm and the brightness (luminous flux) of light extracted from the wavelength conversion member 12.

In accordance with Fig. 12A and Fig. 12B, the thicker the fluorescent layer 12b, the lower the temperature of the fluorescent layer 12b, but the lower the brightness of the extracted light. When the fluorescent layer 12b is thinner, the proportion of fluorophore particles in the fluorescent layer 12b increases, and therefore, the uniformity of the fluorophore particle distribution decreases. In particular, in the case where the thickness of the fluorescent layer 12b is less than 50 µm, there is a possibility that local distribution of the fluorophore particles occurs, causing color unevenness and local heating. For this reason, the thickness of the fluorescent layer 12b is favorably 50 µm or more.

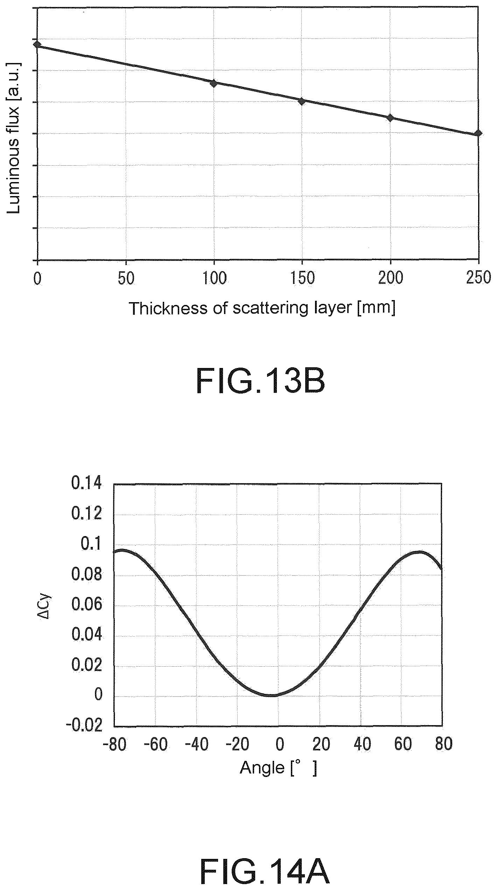

Fig. 13A is a graph showing the relationship between the thickness of the light scattering layer 12a when the thickness of the fluorescent layer 12b was fixed to 50 µm and the thickness of the light scattering layer 12a was changed between 0 to 250 mm and the amount of increase in the temperature of the fluorescent layer 12b from room temperature (25°C) when laser light was applied thereto. Further, Fig. 13B is a graph showing the relationship between the thickness of the light scattering layer 12a when the thickness of the fluorescent layer 12b was fixed to 50 µm and the thickness of the light scattering layer 12a was changed between 0 to 250 mm and the brightness (luminous flux) of light extracted from the wavelength conversion member 12.

In accordance with Fig. 13A and Fig. 13B, the thicker the light scattering layer 12a, the lower the temperature of the fluorescent layer 12b, but the lower the brightness of the extracted light. As shown in Fig. 13A, in the case where the thickness of the light scattering layer 12a is less than 50 µm, the amount of increase in the temperature of the fluorescent layer 12b exceeds 115°C. In this case, when an environmental test is performed at 85°C that is a general environmental test temperature, the temperature of the fluorescent layer 12b exceeds 200°C, the resin forming the fluorescent layer 12b melts, and the wavelength conversion function of the fluorescent layer 12b is lost. For this reason, the thickness of the light scattering layer 12a is favorably 50 µm or more. Further, in order to fully exhibit the wavelength conversion function of the light scattering layer 12a, the amount of increase in the temperature of the fluorescent layer 12b is required to be substantially 100°C or less, and therefore, the thickness of the light scattering layer 12a is favorably 150 µm or more.

The thickness of the wavelength conversion member 12 including the light scattering layer 12a and the fluorescent layer 12b is favorably the thickness capable of processing the wavelength conversion member 12 by scribe and breaking. When the thickness of the wavelength conversion member 12 exceeds 300 µm, it becomes difficult to generate microcracks by scribe and precise processing is difficult. Further, dicing needs to be used to precisely process the wavelength conversion member 12 having the thickness exceeding 300 µm, but there is a possibility that by welding the rotating dicing blade with pressure, the bonding place between the light scattering layer 12a and the fluorescent layer 12b is peeled off and chipping occurs. For this reason, the thickness of the wavelength conversion member 12 is favorably 300 µm or less. The thicknesses of the light scattering layer 12a and the fluorescent layer 12b are favorably such that the thickness of the wavelength conversion member 12 does not exceed 300 µm. For example, the thickness of the light scattering layer 12a is favorably 200 µm or less and the thickness of the fluorescent layer 12b is favorably 100 µm or less.

Next, the relationship between the thicknesses of the light scattering layer 12a and the fluorescent layer 12b when laser light was applied to the wavelength conversion member 12 and the angle dependency of the light extracted from the wavelength conversion member 12 was investigated by simulation.

In this simulation, the planar shape of the wavelength conversion member 12 was made a rectangular shape of 0.5 mm × 1.0 mm and the thickness thereof was set to 200 µm.

Fig. 14A to Fig. 14C each show the relationship between the angle of light extracted from the wavelength conversion member 12 and the chromaticity coordinate Cy of the CIE1931 chromaticity diagram. In Fig. 14A to Fig. 14C, the angle in the direction perpendicular to the light extraction surface of the wavelength conversion member 12 is set to 0°. ΔCy of the vertical axis in Fig. 14A to Fig. 14C represents the amount of change in the chromaticity coordinate Cy from the chromaticity coordinate Cy when the angle is 0°.

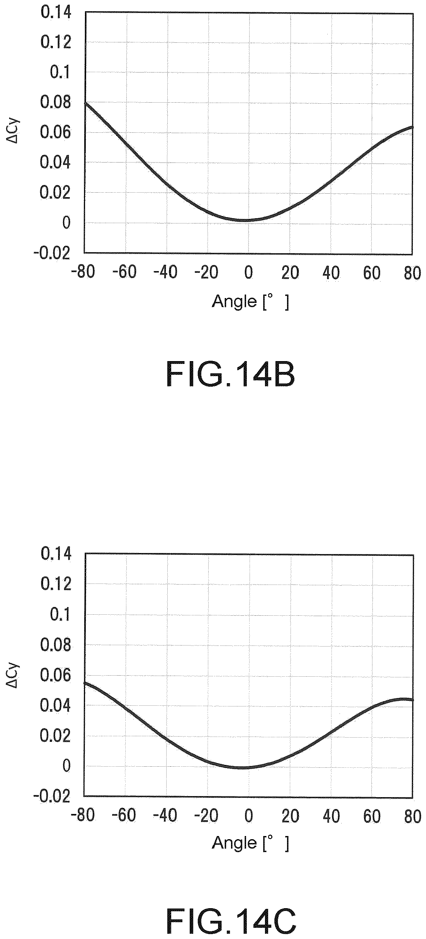

Fig. 14A shows the properties of the wavelength conversion member 12 including only the fluorescent layer 12b. Fig. 14B shows the properties of the wavelength conversion member 12 including the light scattering layer 12a having the thickness of 100 µm and the fluorescent layer 12b having the thickness of 100 µm. Further, Fig. 14C shows the properties of the wavelength conversion member 12 including the light scattering layer 12a having the thickness of 150 µm and the fluorescent layer 12b having the thickness of 50 µm.

Fig. 14A to Fig. 14C each show that the angle dependency of the chromaticity is smaller as the light scattering layer 12a of the wavelength conversion member 12 is thicker. By using the light scattering layer 12a in the wavelength conversion member 12, the application area of laser light to the fluorescent layer 12b is expanded by the scattering effect and the light distribution of laser light is closer to the Lambertian. Further, the thicker the light scattering layer 12a, the closer the light distribution is to the Lambertian. Therefore, the angle dependency of the chromaticity is reduced by the superposition with the fluorescence emitted from the fluorescent layer 12b having the Lambertian orientation property.

### Example 3

The temperatures of the fluorescent layer 12b when laser light was applied to the wavelength conversion member 12 in the light-emitting device 1 according to the first embodiment having the configuration shown in Fig. 1 and the light-emitting device 2 according to the second embodiment having thew configuration shown in Fig. 9A were obtained and compared with each other.

In this simulation, the wavelength conversion member 12 included only the fluorescent layer 12b, the planar shape thereof was made a rectangular shape of 0.5 mm × 1.0 mm, and the thickness thereof was set to 200 µm. The planar shape of the hole of the heat dissipation member 17 in which the wavelength conversion member 12 and the high-heat dissipation light reflector 19 are housed was made a circular shape having a diameter of 1.5 mm. The planar shape of the hole of the high-heat conduction member 13 in which the wavelength conversion member 12 and the light reflection member 14 are housed was made a circular shape having a diameter of 1.5 mm. Further, the thermal conductivities of the light-transmissive heat dissipation member 11, the wavelength conversion member 12, the high-heat conduction member 13, the light reflection member 14, the heat dissipation member 17, and the high-heat dissipation light reflector 19 were respectively set to 25 W/(m·K), 25 W/(m·K), 85 W/(m·K), 5 W/(m·K), 16 W/(m·K), and 4 W/(m·K).

As a result of simulation, in the light-emitting device 1 having the configuration shown in Fig. 1, the maximum temperature of the wavelength conversion member 12 (the fluorescent layer 12b) rose from 25°C to 152.1°C by applying laser light. Meanwhile, in the light-emitting device 2 having the configuration shown in Fig. 9A, the maximum temperature of the wavelength conversion member 12 (the fluorescent layer 12b) rose from 25°C to 125.3° by applying laser light.

The temperature rise value (100.3°C) of the wavelength conversion member 12 in the light-emitting device 2 having the configuration shown in Fig. 9A with respect to the temperature rise value (127.1°C) of the wavelength conversion member 12 in the light-emitting device 1 having the configuration shown in Fig. 1 was 0.79, and it was found that the temperature rise value was reduced to 79% by using the heat dissipation member 17 and the high-heat dissipation light reflector 19.

Although embodiments and Examples of the present invention have been described, the present invention is not limited to the embodiments described above and various modification can be made without departing from the essence of the present invention. Further, components of the embodiments and Examples described above can be arbitrarily combined without departing from the essence of the present invention.

Further, the embodiments and Examples described above do not limit the inventions according to the claims. It should be noted that not all combinations of features described in the embodiments and Examples are essential to the means for solving the problems of the invention.

It should be noted that in accordance with the embodiments and Examples described above, the following light-emitting device according to [1] to [13], the following light-emitting device according to [1] to [13], the wavelength conversion unit according to [14] to [18], and the headlight or a display apparatus according to [19] and [20] can be provided.
[1] A light-emitting device, including:
   a light-emitting element;
   a light-transmissive heat dissipation member having a plate shape, light that is emitted from the light-emitting element passing through the light-transmissive heat dissipation member;
   a wavelength conversion member that includes a laminated layer of a light scattering layer and a fluorescent layer, takes in, from a side of the light scattering layer, light that is emitted from the light-emitting element and passes through the light-transmissive heat dissipation member, and converts a wavelength in the fluorescent layer;
   a lateral heat dissipation member that has a plate shape, includes a high-heat conduction member in contact with a side surface of the wavelength conversion member via a light reflection member, and is in contact with an upper surface of the light-transmissive heat dissipation member; and
   a package that houses the light-emitting element and supports a wavelength conversion unit including the light-transmissive heat dissipation member, the wavelength conversion member, and the lateral heat dissipation member.
[2] The light-emitting device according to [1] above, in which
   a thickness of the light scattering layer is within a range of 50 µm or more and 200 µm or less.
[3] The light-emitting device according to [1] or [2] above, in which
   a thickness of the fluorescent layer is within a range of 50 µm or more and 100 µm or less.
[4] The light-emitting device according to any one of [1] to [3] above, in which
   the light scattering layer is formed of a material obtained by removing an activator of the fluorophore contained in the fluorescent layer from a material of the fluorescent layer.
[5] The light-emitting device according to any one of [1] to [4] above, in which
   the package is bonded to the light-transmissive heat dissipation member and the high-heat conduction member.
[6] The light-emitting device according to any one of [1] to [5] above, in which
   a space inside the package in which the light-emitting element is housed is hermetically sealed by the package and the wavelength conversion unit.
[7] The light-emitting device according to any one of [1] to [6] above, in which
   part or whole of a side surface of the wavelength conversion member on a side of the light-transmissive heat dissipation member has an inclined surface such that a width of the wavelength conversion member is narrowed toward the light-transmissive heat dissipation member.
[8] The light-emitting device according to any one of [1] to [7] above, in which
   the inclined surface and the upper surface of the light-transmissive heat dissipation member are adhered by a light-reflecting adhesive material.
[9] The light-emitting device according to any one of [1] to [8] above, in which
   the lateral heat dissipation member includes a heat dissipation member that has a plate shape, is in contact with the upper surface of the light-transmissive heat dissipation member and a lower surface of the high-heat conduction member, and is in contact with a side surface of the wavelength conversion member directly or via a light reflector, thermal conductivity of the high-heat conduction member is higher than thermal conductivity of the heat dissipation member, and the thermal conductivity of the heat dissipation member is higher than thermal conductivity of the light-transmissive heat dissipation member.
[10] The light-emitting device according to [9] above, in which
   the heat dissipation member has, in a side portion on a side of the wavelength conversion member, a recessed portion for providing a gap between the heat dissipation member and the side surface of the wavelength conversion member.
[11] The light-emitting device according to [10] above, in which
   a light reflection member is provided in the gap.
[12] The light-emitting device according to any one of [1] to [11] above, in which
   an inside of the package is hermetically sealed by a seal member sandwiched between the high-heat conduction member and the package.
[13] The light-emitting device according to any one of [1] to [12] above, which is used for a headlight or a display apparatus.
[14] A wavelength conversion unit, including:
   a wavelength conversion member in which a fluorescent layer containing a fluorophore and a light scattering layer for scattering excitation light of the fluorophore are laminated; a light-transmissive heat dissipation member that has a plate shape and is in contact with a surface of the light scattering layer of the wavelength conversion member, the excitation light passing through the light-transmissive heat dissipation member; and a lateral heat dissipation member that includes a high-heat conduction member that is in contact with a side surface of the wavelength conversion member via a light reflection member and is in contact with an upper surface of the light-transmissive heat dissipation member, in which thermal conductivity of the light-transmissive heat dissipation member is higher than thermal conductivity of the wavelength conversion member, and thermal conductivity of the high-heat conduction member is higher than the thermal conductivity of the light-transmissive heat dissipation member.
[15] The wavelength conversion unit according to [14] above, in which
   a thickness of the light scattering layer is within a range of 50 µm or more and 200 µm or less.
[16] The wavelength conversion unit according to [14] or [15] above, in which
   a thickness of the fluorescent layer is within a range of 50 µm or more and 100 µm or less.
[17] The wavelength conversion unit according to any one of [14] to ]16] above, in which
   the light scattering layer is formed of a material obtained by removing an activator of the fluorophore contained in the fluorescent layer from a material of the fluorescent layer.
[18] The wavelength conversion unit according to any one of [14] to ]17] above, which is used for a headlight or a display apparatus.
[19] A headlight or a display apparatus, including:
   the light-emitting device according to any one of [1] to ]12] above.
[20] A headlight or a display apparatus, including:
   the wavelength conversion unit according to any one of [14] to ]17] above.

### Industrial Applicability

There are provided a light-emitting device having a structure capable of suppressing the amount of heat generated by the wavelength conversion member and effectively releasing the heat of the wavelength conversion member to suppress the temperature quenching of the fluorophore, a wavelength conversion unit constituting the light-emitting device, and a headlight or a display apparatus including the light-emitting device or the wavelength conversion unit.

### Reference Signs List

1, 2, 3 light-emitting device
11, 15 light-transmissive heat dissipation member
12 wavelength conversion member
12a light scattering layer
12b fluorescent layer
13 high-heat conduction member
14 light reflection member
15b AR film
15c DBR film
17 heat dissipation member
17a recessed portion
18 light reflection member
19 high-heat dissipation light reflector
20 light-emitting element
21 package
100, 200 wavelength conversion unit

## Claims

1. A light-emitting device, comprising:
a light-emitting element;
a light-transmissive heat dissipation member having a plate shape, light that is emitted from the light-emitting element passing through the light-transmissive heat dissipation member;
a wavelength conversion member that includes a laminated layer of a light scattering layer and a fluorescent layer, takes in, from a side of the light scattering layer, light that is emitted from the light-emitting element and passes through the light-transmissive heat dissipation member, and converts a wavelength in the fluorescent layer;
a lateral heat dissipation member that has a plate shape, includes a high-heat conduction member in contact with a side surface of the wavelength conversion member via a light reflection member, and is in contact with an upper surface of the light-transmissive heat dissipation member; and
a package that houses the light-emitting element and supports a wavelength conversion unit including the light-transmissive heat dissipation member, the wavelength conversion member, and the lateral heat dissipation member.

2. The light-emitting device according to claim 1, wherein
a thickness of the light scattering layer is within a range of 50 µm or more and 200 µm or less.

3. The light-emitting device according to claim 1, wherein
a thickness of the fluorescent layer is within a range of 50 µm or more and 100 µm or less.

4. The light-emitting device according to claim 1, wherein
the light scattering layer is formed of a material obtained by removing an activator of the fluorophore contained in the fluorescent layer from a material of the fluorescent layer.

5. The light-emitting device according to claim 1, wherein
the package is bonded to the light-transmissive heat dissipation member and the high-heat conduction member.

6. The light-emitting device according to claim 1, wherein
a space inside the package in which the light-emitting element is housed is hermetically sealed by the package and the wavelength conversion unit.

7. The light-emitting device according to claim 1, wherein
part or whole of a side surface of the wavelength conversion member on a side of the light-transmissive heat dissipation member has an inclined surface such that a width of the wavelength conversion member is narrowed toward the light-transmissive heat dissipation member.

8. The light-emitting device according to claim 1, wherein
the inclined surface and the upper surface of the light-transmissive heat dissipation member are adhered by a light-reflecting adhesive material.

9. The light-emitting device according to claim 1, wherein
the lateral heat dissipation member includes a heat dissipation member that has a plate shape, is in contact with the upper surface of the light-transmissive heat dissipation member and a lower surface of the high-heat conduction member, and is in contact with a side surface of the wavelength conversion member directly or via a light reflector, thermal conductivity of the high-heat conduction member is higher than thermal conductivity of the heat dissipation member, and the thermal conductivity of the heat dissipation member is higher than thermal conductivity of the light-transmissive heat dissipation member.

10. The light-emitting device according to claim 9, wherein
the heat dissipation member has, in a side portion on a side of the wavelength conversion member, a recessed portion for providing a gap between the heat dissipation member and the side surface of the wavelength conversion member.

11. The light-emitting device according to claim 10, wherein
a light reflection member is provided in the gap.

12. The light-emitting device according to claim 1, wherein
an inside of the package is hermetically sealed by a seal member sandwiched between the high-heat conduction member and the package.

13. The light-emitting device according to claim 1, which is used for a headlight or a display apparatus.

14. A wavelength conversion unit, comprising:
a wavelength conversion member in which a fluorescent layer containing a fluorophore and a light scattering layer for scattering excitation light of the fluorophore are laminated; a light-transmissive heat dissipation member that has a plate shape and is in contact with a surface of the light scattering layer of the wavelength conversion member, the excitation light passing through the light-transmissive heat dissipation member; and a lateral heat dissipation member that includes a high-heat conduction member that is in contact with a side surface of the wavelength conversion member via a light reflection member and is in contact with an upper surface of the light-transmissive heat dissipation member, wherein thermal conductivity of the light-transmissive heat dissipation member is higher than thermal conductivity of the wavelength conversion member, and thermal conductivity of the high-heat conduction member is higher than the thermal conductivity of the light-transmissive heat dissipation member.

15. The wavelength conversion unit according to claim 14, wherein
a thickness of the light scattering layer is within a range of 50 µm or more and 200 µm or less.

16. The wavelength conversion unit according to claim 14, wherein
a thickness of the fluorescent layer is within a range of 50 µm or more and 100 µm or less.

17. The wavelength conversion unit according to claim 14, wherein
the light scattering layer is formed of a material obtained by removing an activator of the fluorophore contained in the fluorescent layer from a material of the fluorescent layer.

18. The wavelength conversion unit according to claim 14, which is used for a headlight or a display apparatus.

19. A headlight or a display apparatus, comprising:
the light-emitting device according to claim 1.

20. A headlight or a display apparatus, comprising:
the wavelength conversion unit according to claim 14.
